(19) Europäisches Patentamt / European Patent Office / Office européen des brevets

(11) **EP 1 845 550 A1**

(12) **EUROPEAN PATENT APPLICATION**

(43) Date of publication:
**17.10.2007 Bulletin 2007/42**

(51) Int Cl.:
***H01J 17/49*** *(2006.01)*

(21) Application number: **07251554.7**

(22) Date of filing: **11.04.2007**

(84) Designated Contracting States:
**AT BE BG CH CY CZ DE DK EE ES FI FR GB GR HU IE IS IT LI LT LU LV MC MT NL PL PT RO SE SI SK TR**
Designated Extension States:
**AL BA HR MK YU**

(30) Priority: **11.04.2006 KR 20060032665**

(71) Applicant: **Samsung SDI Co., Ltd.**
**Suwon-si,**
**Gyeonggi-do (KR)**

(72) Inventors:
• **Cha, Jun-Kyu,**
**c/o Samsung SDI Co. Ltd.**
**Suwon-si,**
**Gyeonggi-do (KR)**

• **Bae, Jae-Woo,**
**c/o Samsung SDI Co. Ltd.**
**Suwon-si,**
**Gyeonggi-do (KR)**
• **Moon, Dong-Gun,**
**c/o Samsung SDI Co. Ltd.**
**Suwon-si,**
**Gyeonggi-do (KR)**
• **Shim, Myun-Gi,**
**c/o Y.P. Lee, Mock & Partners**
**Seocho-Gu,**
**Seoul (KR)**
• **Hur, Sang-Yeol,**
**c/o Samsung SDI Co. Ltd.**
**Suwon-si,**
**Gyeonggi-do (KR)**

(74) Representative: **Mounteney, Simon James**
**Marks & Clerk**
**90 Long Acre**
**London WC2E 9RA (GB)**

(54) **Filter assembly and plasma display device including the same**

(57) A filter assembly (250) includes a base film (251), an electromagnetic wave shielding filter (252) on the base film, and a surface reflection film (253) on the base film, the surface reflection film having a haze of less than about 20% and a mirror reflectivity of less than about 1 %. The filter assembly may be in front of a panel assembly (210) of a display (200), e.g., may directly contact a display surface of the panel assembly.

FIG. 1

**(Cont. next page)**

# FIG. 3

258 257 256 255 254

253 251 252

250

211

**Description**

BACKGROUND OF THE INVENTION

1. Field of the Invention

The present invention relates to a plasma display device. More particularly, the present invention relates to a filter assembly having an improved structure to enhance optical features of a panel assembly and a plasma display device including the same.

2. Description of the Related Art

Plasma display devices are flat panel display devices which display a desired image including text or graphics using a discharge gas injected into a sealed space of a panel assembly in which a plurality of discharge electrodes are disposed, and applying a predetermined discharge voltage to the discharge electrodes such that phosphor layers in a discharge space emit light due to the discharge voltage. Plasma display devices may be divided into direct current (DC) type plasma display devices and alternating current (AC) type plasma display devices with respect to a type of driving voltage required, and may be further divided into facing surface discharge type plasma display devices and surface discharge type plasma display devices with respect to the arrangement of discharge electrodes therein.

During operation of a plasma display device, electromagnetic waves and infrared (IR) light may be emitted from driving circuit boards therein. Further, the discharge gas may emit light at wavelengths other than those required to excite the phosphor. For example, when neon is included in the discharge gas, light in a wavelength region of about 590 nm may be emitted. All of these wavelengths may be filtered out before reaching a viewer, as the electromagnetic waves may be harmful to humans, the IR light may cause functional errors of portable electronic devices, e.g., a remote control, and visible light emitted by the discharge gas may deteriorate image quality. Also, an anti-reflection (AR) structure may be needed to prevent reduction of visibility due to reflection of external light.

In conventional plasma display devices, an AR film or an electromagnetic wave shielding filter may be attached to a thick glass substrate or a thick plastic substrate, and combined together by a supporting medium, e.g., a filter holder in front of the panel assembly. However, when a thick glass substrate or a thick plastic substrate is used, the substrate may diffuse the light, may increase manufacturing costs and complicate the manufacturing process as required components are increased.

SUMMARY OF THE INVENTION

The present invention is therefore directed to a filter assembly and a display device including the same, which substantially overcome one or more of the problems due to the limitations and disadvantages of the related art.

It is accordingly an object of the present invention to provide an integrally assembled filter assembly, and a plasma display device adopting the same.

It is accordingly another object of the present invention to provide a filter assembly having optimal efficiency, and a plasma display device adopting the same.

It is another object of the present invention to provide a filter assembly having improved visibility, and a plasma display device adopting the same.

It is accordingly another object of the present invention to provide a filter assembly having reduced mirror reflectivity, and a plasma display device adopting the same.

Accordingly a first aspect of the invention provides a filter assembly, including a base film, an electromagnetic wave shielding filter on the base film, and a surface reflection film on the base film, the surface reflection film having a haze of less than about 20% and a mirror reflectivity of less than about 1%.

The surface reflection film may include an anti-glare film including a plurality of protrusions having a diameter of about 1 nm ~ 1 mm on a surface thereof and/or an anti-reflection film including a low refractive index layer and a high refractive index layer stacked on one another. The surface reflection film may have a haze of about 0.5 ~ 10%.

The electromagnetic wave shielding filter may be on one surface of the base film and the surface reflection film may be on an opposite surface of the base film. The base film may include at least one of a near infrared ray shielding film, a transmittance control film and a wavelength selective absorption film. The wavelength selective absorption film may have a maximum absorption in a wavelength range of about 560 ~ 610 nm.

The electromagnetic wave shielding filter may include a mesh-patterned conductive material. The conductive material may include at least one of Cu, Ag, Al, Pt, Au, Fe or an alloy thereof. The electromagnetic wave shielding filter may include a metal layer and a metal oxide layer stacked one on the other.

A second aspect of the invention provides a plasma display device, including a panel assembly including first and second substrates, a chassis base assembly attached to the panel assembly and including driving circuit boards which transfer electrical signals to and from the panel assembly, and a filter assembly in front of the panel assembly, the filter assembly including a base film, an electromagnetic wave shielding filter formed on the base film, and a surface reflection film formed on the base film, the surface reflection film having a haze of less than about 20% and a mirror reflectivity of less than about 1%.

The filter assembly may directly contact a front surface of the first substrate. The filter assembly may maintain a transmittance of about 40%. The plasma display device may further include a case adapted to accommodate the panel assembly, the chassis base and the filter assembly.

BRIEF DESCRIPTION OF THE DRAWINGS

The above and other features and advantages of the present invention will become more apparent to those of ordinary skill in the art upon making reference to the following description of embodiments thereof which is given with reference to the attached drawings, in which:

FIG. 1 is an exploded perspective view of a plasma display device according to an embodiment of the present invention;
FIG. 2 is a cross-sectional view of the combined plasma display device of FIG. 2;
FIG. 3 is a magnified cross-sectional view of a filter assembly according to an embodiment of the present invention;
FIG. 4 is a magnified cross-sectional view of a filter assembly according to another embodiment of the present invention;
FIG. 5 is a magnified cross-sectional view of a filter assembly according to another embodiment of the present invention;
FIG. 6 is a magnified cross-sectional view of a filter assembly according to another embodiment of the present invention;
FIG. 7 is a plan view of an electromagnetic wave shielding filter according to the present invention;
FIG. 8 is a magnified view of a portion of the electromagnetic wave shielding filter of FIG. 8;
FIG. 9 illustrates a structure of a conventional haze meter; and
FIG. 10 illustrates a graph of wavelength versus transmittance.

DETAILED DESCRIPTION OF THE INVENTION

The present invention will now be described more fully hereinafter with reference to the accompanying drawings, in which embodiments of the invention are illustrated. The invention may, however, be embodied in different forms and should not be construed as limited to the embodiments set forth herein. Rather, these embodiments are provided so that this disclosure will be thorough and complete, and will fully convey the scope of the invention to those skilled in the art.

In the figures, the dimensions of layers and regions may be exaggerated for clarity of illustration. It will also be understood that when a layer or element is referred to as being "on" another layer or substrate, it can be directly on the other layer or substrate, or intervening layers may also be present. Further, it will be understood that when a layer is referred to as being "under" another layer, it can be directly under, and one or more intervening layers may also be present. In addition, it will also be understood that when a layer is referred to as being "between" two layers, it can be the only layer between the two layers, or one or more intervening layers may also be present. Like reference numerals refer to like elements throughout.

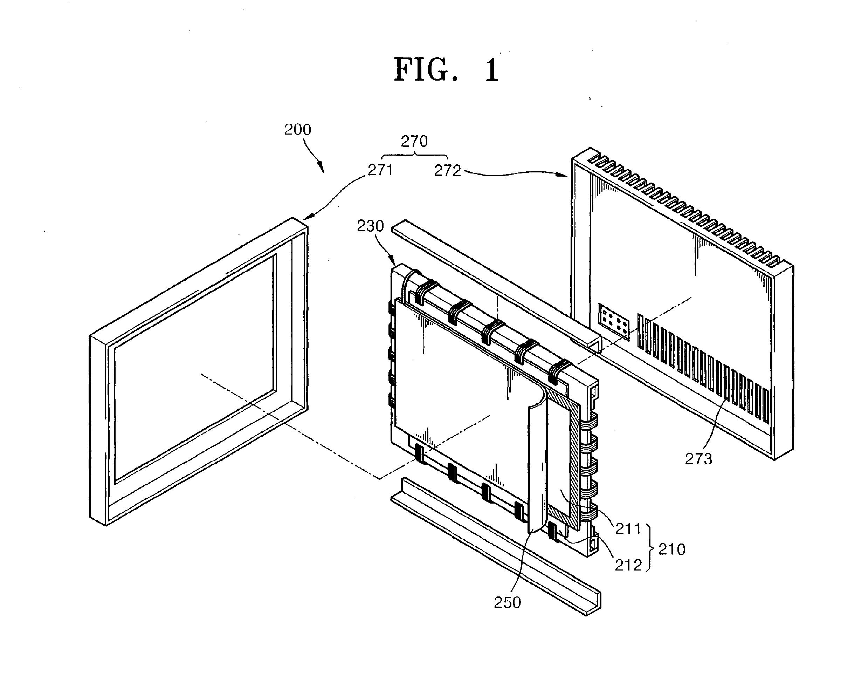

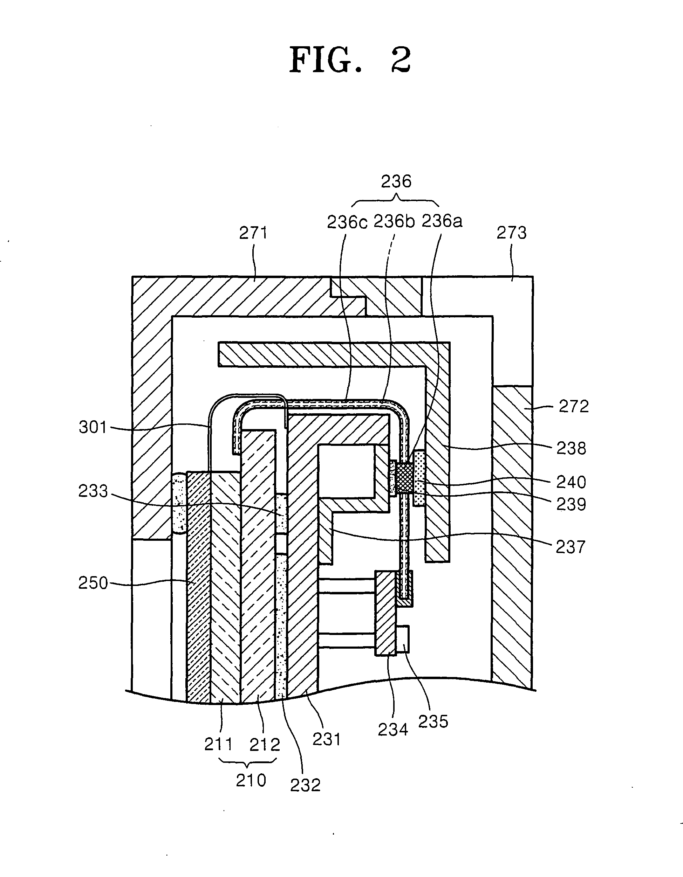

FIG. 1 illustrates an exploded perspective view of a plasma display device 200 according to an embodiment of the present invention. FIG. 2 illustrates a cross-sectional view of the plasma display device 200 of FIG. 1.

Referring to FIGS. 1 and 2, the plasma display device 200 includes a panel assembly 210, a chassis base assembly 230 attached to a rear surface of the panel assembly 210, a filter assembly 250 attached to a front surface of the panel assembly 210, and a case 270, which accommodates the panel assembly 210, the chassis base assembly 230, and the filter assembly 250.

The panel assembly 210 includes a first substrate 211 and a second substrate 212. A space between the first and second substrates 211 and 212 is sealed.

The chassis base assembly 230 includes a chassis base 231, which is attached to the rear surface of the panel assembly 210, in this case using adhesive materials. The adhesive materials include a thermal conductive sheet 232 at the center of the rear surface of the second substrate 212, the thermal conductive sheet 232 being adapted to transfer heat generated from the panel assembly 210 during operation thereof to the chassis base 231, and double-sided tape 233 along edges of the rear surface of the second substrate 212.

A plurality of driving circuit boards 234 are disposed on the rear surface of the chassis base 231. A plurality of circuit elements 235 are included on the driving circuit boards 234. The circuit elements 235 are electrically connected to one end of a signal transfer unit 236, via a flexible printed cable. The other end of the signal transfer unit 236 is electrically connected to an electrode terminal of the panel assembly 210, and may be adapted to transfer electrical signals between the panel assembly 210 and the driving circuit board 235. The signal transfer unit 236 includes a driving integrated circuit (IC) 236a, a plurality of leads 236b, and a flexible film 236c to cover the leads 236b.

A chassis reinforcing member 237 is attached at the top and bottom of the rear surface of the chassis base 231 to strengthen the chassis base 231. A cover plate 238 is disposed to protect the signal transfer unit 236 from damage. In other words, the signal transfer unit 236 is situated between the chassis base 231 and the cover plate 238. Thermal grease 239 is provided between the driving IC 236a and the chassis reinforcing member 237, and a silicon layer 240 is provided between the driving IC 236a and the cover plate 238.

The filter assembly 250 is attached to the front surface of the first substrate 211. The filter assembly 250 is a multi-layer structure including a plurality of layers stacked on one another to block electromagnetic waves and infrared (IR) light generated from the panel assembly 210, to block visible emission from the discharge gas and to block reflection of external light. Here, the filter assembly 250 is directly attached to the front surface of the panel assembly 210.

The case 270 houses the panel assembly 210, the chassis base assembly 230 and the filter assembly 250. The case 270 includes a front cabinet 271 in front of the filter assembly 250 and a back cover 272 behind the chassis base assembly 230. A plurality of air holes 273 may be on the top and bottom of the back cover 272.

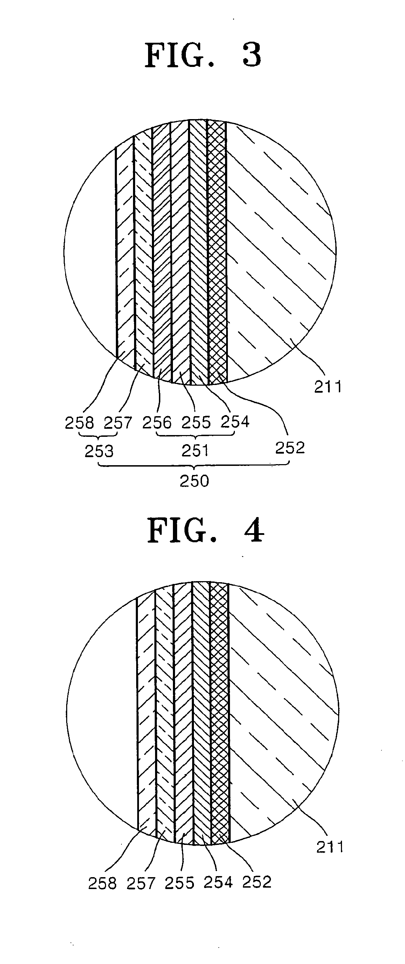

Referring to FIG. 3, the filter assembly 250 includes a base film 251, an electromagnetic wave shielding filter 252 formed on one surface of the base film 251, and a surface reflection film 253 formed on the other surface of the base film 251. The base film 251 includes a near IR shielding film 254, a transmittance control film 255 and a wavelength selective absorption film 256.

The near IR shielding film 254 serves to reduce or prevent emission of near IR light generated by plasma of an inactive gas used in a light emitting process. The transmittance control film 255 serves to control an amount of light transmitted through the filter assembly 250. In an embodiment of the present invention, a transmittance of 40% may be maintained. The wavelength selective absorption film 256 serves to block visible light emitted from the discharge gas, e.g., when neon is used, and may block light within a wavelength region of about 590 nm. In the present example, a maximum absorption may be in a wavelength range of about 560 ~ 610 nm. The near IR shielding film 254, the transmittance control film 255 and the wavelength selective absorption film 256 may be sequentially attached to each other. The base film 251 may further include additional films performing various functions.

The electromagnetic wave shielding filter 252 is disposed between the first substrate 211 and the base film 251. The electromagnetic wave shielding filter 252 is attached directly to the front surface of the first substrate 211. That is, a separate space need not be formed between the first substrate 211 and the filter assembly 250, i.e., the electromagnetic wave shielding filter 252 contacts the first substrate 211.

Electromagnetic waves, generated by the panel assembly 210 or circuit elements 235 of the driving circuit boards 234, during operation of a plasma display device 200 may cause functional errors of other electronic devices and may be harmful to humans. Accordingly, the electromagnetic waves should to be blocked, and the electromagnetic wave shielding filter 252 blocks the electromagnetic waves.

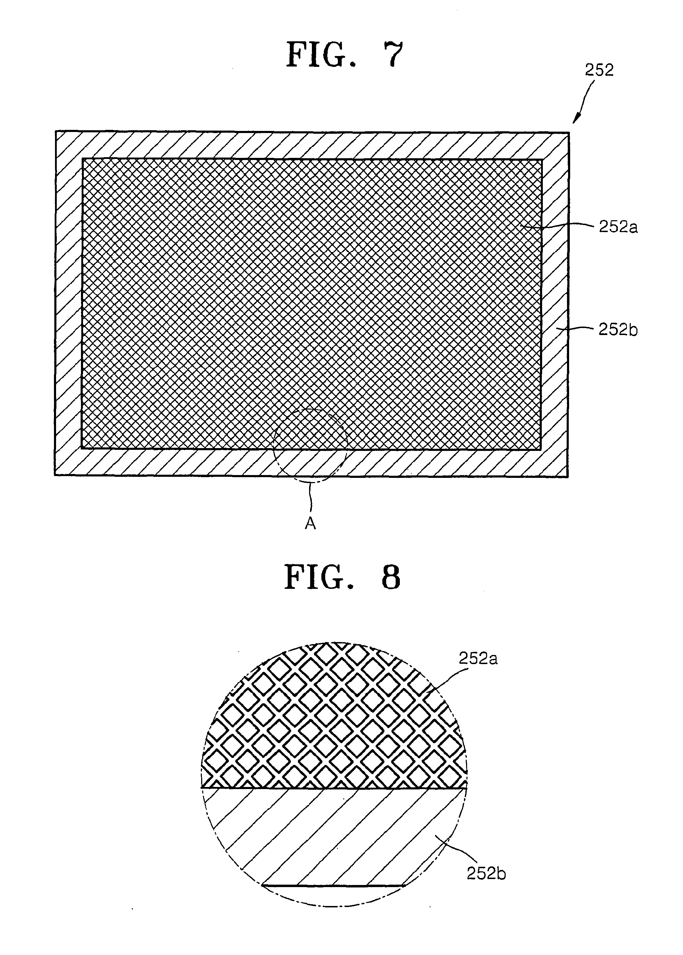

FIG. 7 illustrates a plan view of an electromagnetic wave shielding filter 252 according to an embodiment of the present invention. FIG. 8 illustrates a magnified view of a portion A of the electromagnetic wave shielding filter 252 of FIG. 7.

The electromagnetic wave shielding filter 252 includes fine metal meshes 252a and a conductive sheet 252b. The metal meshes 252a are patterned in the central area of the conductive sheet 252b corresponding to the first substrate 211.

The electromagnetic wave shielding filter 252 are formed of a material having high electrical conductivity, e.g., Cu, Ag, Al, Pt, Au, Fe or an alloy thereof. A ceramic material having conductivity or carbon nanotubes may also be used.

The conductive sheet 252b is connected to an edge of the chassis base 231 by a conductive line 301. Alternatively, the conductive line 301 may be connected to a conductive material of the case 270.

The metal meshes 252a of the electromagnetic wave shielding filter 252 may be patterned using a variety of methods, however, coating or etching may simplify the manufacturing method and standardize the pattern.

Alternatively, the electromagnetic wave shielding filter 252 may be formed of a transparent conductive layer, e.g., an indium tin oxide (ITO) layer, and a metal layer, e.g., a copper layer which may be oxidized and stacked on the transparent conductive layer.

Referring again to FIG. 3, the surface reflection film 253 is formed on the front surface of the base film 251, i.e., on a surface opposite a surface of the base film 251 that faces the first substrate 211.

The surface reflection film 253 includes an anti-glare film (AG film) 257 and an anti-reflection film (AR film) 258, which are attached to the front surface of the AG film 257, to prevent reduction of visibility due to reflection of external light.

The AG film 257 includes protrusions having a diameter of about 1 nm ~ 1 mm, e.g., about 0.5 ~ 20 μm, on the surface of the AG film 257. These protrusions serve to diffuse light. The distribution area of the protrusions may be less than or equal to about 50% of the total surface area of the AG film 257. If the distribution area of the protrusions is greater than about 50% of the total surface area of the AG film 257, reflection of external light by the AG film 257 may be reduced, but a haze of the AG film 257 may increase when an image formed on a panel passes through the AG film 257 such that a high-contrast image may not be obtained.

The AR film 258 serves to reduce light reflection using a phase difference due to a stacking of a low refractive index layer and a high refractive index layer on one another. The surface reflection film 253 including the AG film 257 and the AR film 258 may have a haze of less than or equal to about 20%, e.g., about 0.5 ~ 10%. If the haze of the surface reflection film 253 is greater than about 20%, image contrast may be reduced. A mirror reflectivity of the surface reflection film 253 may be less than about 1%.

The AG film 257 may include a transparent substrate and a plurality of beads on a surface of the transparent substrate. The transparent substrate of the AG film may be formed of a transparent material, e.g., glass, PET(Polyethylene Terephthalate) film, TAC(tri-acetyl-cellulose) film, PVA(polyvinyl alcohol) film, PE(polyethylene) film. The thickness of the transparent substrate may be about 10 $\mu$m to about 1000 $\mu$m. A plurality of beads may be formed of a light transmittable material, e.g., stylene , melanin, acrylic resin, acrylic-stylene, polycarbonate, polyethylene, polyvinyl chloride, or a metal oxide, e.g., $SiO_2$, $AlSiO_2$, $ZrO_2$, $GeO_2$ or $Al_2O_3$. The light transmittable material may have an average particle size of about 0.1 $\mu$m to about 20 $\mu$m.

The AR film 258 may include a transparent substrate and a stacked structure of a low refractive index layer and a high refractive index layer formed on the surface of the transparent substrate. The transparent substrate of the AR film may be the same as the transparent substrate of the AG film. A low refractive index layer and a high refractive index layer may be formed by stacking at least two materials selected from, e.g., acrylate resin, cellulose series resin, epoxy resin, urea-melamine resin and urethane resin.

A combined film having the AG film 257 and the AR film 258 may include a transparent substrate and a stacked structure of a low refractive index layer and a high refractive index layer on one another on the surface of the transparent substrate, and a plurality of beads formed on a surface of the low refractive index layer.

In some embodiments, one or the other of the AG film and the AR film are omitted.

The films 251 to 253 may be combined in different ways to form variations on the filter assembly, as illustrated, for example, in FIGS. 4, 5, and 6.

FIG. 4 illustrates a magnified cross-sectional view of a filter assembly according to another embodiment of the present invention.

Referring to FIG. 4, the electromagnetic wave shielding filter 252 is situated directly on the front surface of the first substrate 211 and the near IR shielding film 254 and the transmittance control film 255 are sequentially attached on the front surface of the electromagnetic wave shielding filter 252. The AG film 257 and the AR film 258 are sequentially located on the front surface of the transmittance control film 255. Here, the surface reflection film 253 including the AG film 257 and the AR film 258 may have a haze of less than or equal to about 20%, e.g., about 0.5 ~ 10%, and a mirror reflectivity of less than about 1%.

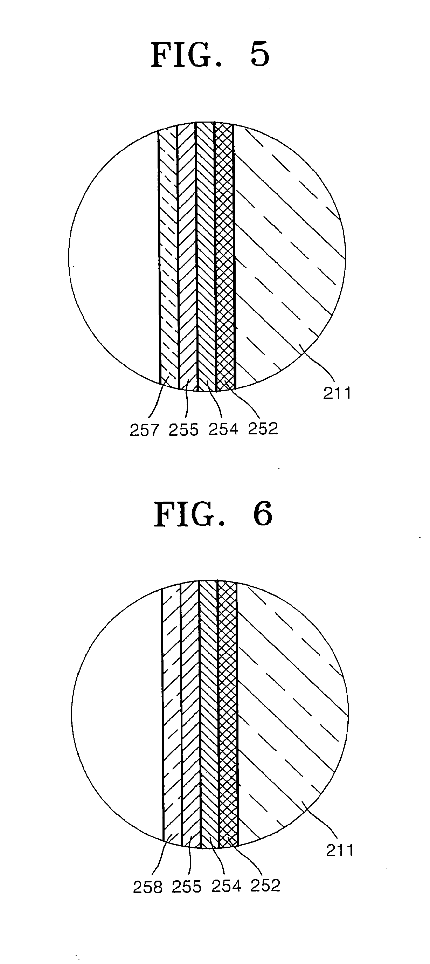

FIG. 5 illustrates a magnified cross-sectional view of a filter assembly according to another embodiment of the present invention

Referring to FIG. 5, the electromagnetic wave shielding filter 252 is situated directly on the front surface of the first substrate 211, and the near IR shielding film 254 and the transmittance control film 255 are located sequentially on the front surface of the electromagnetic wave shielding filter 252. The AG film 257 is provided on the front surface of the transmittance control film 255. Here, the AG film 257 may have a haze of less than or equal to about 20%, e.g., about 0.5 ~ 10%, and a mirror reflectivity of less than about 1%.

FIG. 6 illustrates a magnified cross-sectional view of a filter assembly according to another embodiment of the present invention.

Referring to FIG. 6, the electromagnetic wave shielding filter 252 is provided directly on the front surface of the first substrate 211, and the near IR shielding film 254 and the transmittance control film 255 are located sequentially on the front surface of the electromagnetic wave shielding filter 252. The AR film 258 may be on the front surface of the transmittance control film 255. Here, the AR film 258 is located a haze of less than or equal to about 20%, e.g., about 0.5 ~ 10%, and a mirror reflectivity of less than about 1%.

Electromagnetic waves may be generated from the panel assembly 210 or circuit elements 235 of the driving circuit boards 234 during operation of a plasma display device 200 having the structure described above. The electromagnetic waves may impinge on the electromagnetic wave shielding filter 252 attached directly to the front surface of the first substrate 211 and may be grounded to the chassis base 231 through the conductive line 301, which is electrically connected to the electromagnetic wave shielding filter 252.

Furthermore, near IR light may be blocked by the near IR shielding film 254, visible light emitted by the discharge gas may be blocked by the wavelength selective absorption film 256 and reduction of visibility due to reflection of external light may be improved by a surface reflection film 253.

Features of examples of filter assemblies according to he present invention were investigated by experiments performed by the present applicant, the results of which are shown in the following Table 1. In Table 1, all of the examples were situated directly on the first substrate 211. Comparison example 1 is an AR film, comparison example 2 is an AG film, and each of examples 1 and 2 is a combined film including the AG film and the AR film.

[TABLE 1]

|  | Haze of filter (%) | Haze of surface reflection film (%) | Mirror reflectivity (%) | Reflection of external objects | Visibility evaluation |
|---|---|---|---|---|---|
| Example 1 | 4.7 | 2.95 | 0.87 | Did not occur | Passed |
| Example 2 | 8.87 | 5.70 | 0.44 | Did not occur | Passed |
| Comparison example 1 | 2.3 | 0.6 | 1.08 | Occurred | Passed |
| Comparison example 2 | 32.3 | 30 | 0.03 | Did not occur | Does not pass |

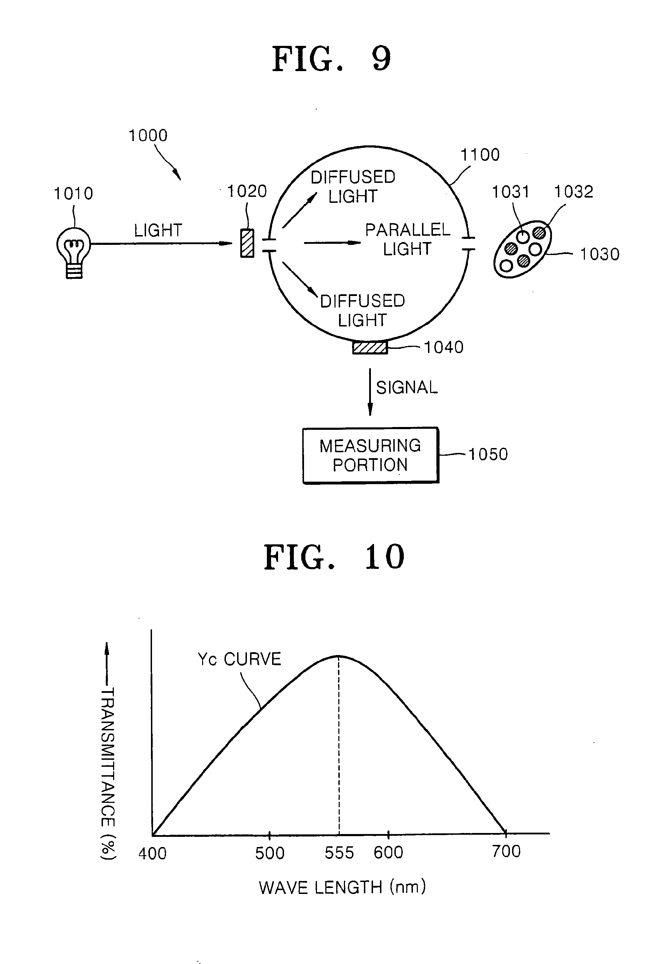

FIG. 9 illustrates an internal structure of a sensor in a haze meter 1000.

Here, a haze meter NPH 2000 of Nippon Denshoku Kogyo is used and a method of measuring haze using the haze meter 1000 is illustrated as shown in FIG. 9.

Referring to FIG. 9, light generated from a halogen lamp 1010 is transmitted through a transparent or semitransparent sample 1020 and enters into an integrating sphere 1100 having a diameter of 150 mm.

Here, light is divided into diffuse light and parallel light which are reflected in the integrating sphere 1100. The diffuse light is incident on a photodetector 1040. A whole internal surface of the integrating sphere 1100 is coated with a reflective material, e.g., $BaSO_4$, such that light is reflected on the whole internal surface of the integrating sphere 1100.

A signal generated due to the light being incident on the photodetector 1040 is transferred to a measuring portion 1050 to display data results. Also, the amount of parallel light may be calculated using a motorized unit 1030. In the motorized unit 1030, light is reflected by white circles 1031 and transmitted through black circles 1032 such that the light is divided into transmitted light and parallel light. The motorized unit 1030 is rotated throughout the measuring process.

The haze may be calculated using Equation 1 below:

$$\text{haze (\%)} = (\text{diffused light / total transmitted light}) \times 100 \qquad (1)$$

Here, the amount of parallel light may be calculated when the amount of diffused light is subtracted from the total amount of transmitted light using Equation 2 below:

$$\text{parallel light} = \text{total transmitted light} - \text{diffused light} \qquad (2)$$

FIG. 10 illustrates a graph of wavelength versus transmittance. Haze is a feature of luminance Yc over the visible range of 400 ~ 700 nm. Yc may be used according to an international standard. When an X axis is for wavelength (nm), here shown across the visible range, and a Y axis is for transmittance (%), the Yc curve is distributed throughout the whole visible range. In particular, a peak transmittance of the Yc curve occurs at a wavelength of 555 nm, as illustrated in FIG. 10.

Mirror reflectivity may be calculated by measuring an amount of light incident at 30° and reflected using, e.g., Darsa pro-5000 (PSI, Korea).

Meanwhile, copper meshes having an aperture ratio of 90% are used for an electromagnetic wave shielding filter 252, a total transmittance of the filter assembly 250 is maintained at 40%, the AR film 258 (comparison example 1) or the AG film 257 (comparison example 2) or a combined film (example 1 or 2) including the AG film 257 or the AR film 258 is used for a surface reflection film 253 having a haze of X1%, wherein the filter assembly 250 has a haze of X2%. An absolute value of mirror reflectivity of glass to which the filter assembly 250 is attached is 4.2%.

Referring to TABLE 1, in comparison example 1, the haze of the filter is 2.3%, the haze of the surface reflection film is 0.6%, mirror reflectivity is 1.08%, reflection of objects occurs, and visibility passes the standard. In comparison example 2, the haze of the filter is 32.3%, the haze of the surface reflection film is 30%, mirror reflectivity is 0.03%, reflection of objects does not occur, and visibility does not pass the standard.

On the other hand, as shown in TABLE 1, in example 1, the haze of the filter is 4.7%, the haze of the surface reflection film haze is 2.95%, mirror reflectivity is 0.87%, reflection of objects by mirror reflection does not occur, and visibility passes the standard. In example 2, the haze of the filter is 8.87%, the haze of the surface reflection film is 5.7%, mirror reflectivity is 0.44%, reflection of objects by mirror reflection does not occur, and visibility passes the standard.

It may be preferable that the haze of the filter, the haze of the surface reflection film, and mirror reflectivity have as small values as possible. In examples 1 and 2 according to embodiments of the present invention, the hazes of the filters are 4.7% and 8.87%, respectively, the hazes of the surface reflection films are 2.95% and 5.7%, respectively, and the mirror reflectivities are 0.87% and 0.44%, respectively. Compared to comparison example 2 in which the haze of the filter is 32.3%, the haze of the surface reflection film is 30%, and mirror reflectivity is 0.03%. Thus, the hazes of the filter and the surface reflection film are smaller and the mirror reflectivities are greater in examples 1 and 2 than in comparison example 2. Reflection of objects does not occur and visibility is excellent in examples 1 and 2, while visibility is not excellent in comparison example 2.

In comparison example 1, the haze of the filter is 2.3%, the haze of the surface reflection film is 0.6%, and mirror reflectivity is 1.08%. The haze of the filter and the surface reflection film is larger and the mirror reflectivities are smaller in examples 1 and 2 than in comparison example 1. Reflection of objects does not occur and visibility is excellent in examples 1 and 2, while reflection of objects does occur in comparison example 1.

As described above, in the filter assemblies 250 according to the present invention, reflection of objects by mirror reflection does not occur and visibility passes the standard.

A filter assembly and a plasma display device adopting the filter assembly according to embodiments of the present invention may provide at least one or more of the following advantages.

First, mirror reflection of objects may be reduced or eliminated while allowing visibility to be excellent by adopting a surface reflection film having a haze value in a predetermined range.

Second, quality of a plasma display device can be increased by including at least one of an AG film and an AR film having a haze value in a predetermined range.

Third, since a filter assembly may be attached directly to the front surface of a panel assembly, an additional supporting medium may not be needed, and the filter assembly may have fewer components and may be thinner.

Embodiments of the present invention have been disclosed herein, and although specific terms are employed, they are used and are to be interpreted in a generic and descriptive sense only and not for purpose of limitation. Accordingly, it will be understood by those of ordinary skill in the art that various changes in form and details may be made without departing from the scope of the present invention as set forth in the following claims.

## Claims

1.  A filter assembly, comprising:

    a base film;
    an electromagnetic wave shielding filter on the base film; and
    a surface reflection film on the base film, the surface reflection film having a haze of 20% or less and a mirror reflectivity of 1% or less.

2.  A filter assembly as claimed in claim 1, wherein the surface reflection film comprises an anti-glare film including a plurality of protrusions having a diameter of from 1 nm ~ 1 mm on a surface thereof.

3.  A filter assembly as claimed in claim 1 or 2, wherein the surface reflection film has a haze of about 0.5 ~ 10%.

4.  A filter assembly as claimed in claim 1, 2 or 3, wherein the surface reflection film comprises an anti-reflection film including a low refractive index layer and a high refractive index layer stacked on one another.

5.  The filter assembly as claimed in any preceding claim, wherein the electromagnetic wave shielding filter is on one surface of the base film and the surface reflection film is on an opposite surface of the base film.

6.  The filter assembly as claimed in claim 1, wherein the base film comprises at least one of a near infrared ray shielding film, a transmittance control film and a wavelength selective absorption film.

7.  A filter assembly as claimed in claim 6, wherein the wavelength selective absorption film has a maximum absorption in a wavelength range of about 560 ~ 610 nm.

8.  A filter assembly as claimed in any preceding claim, wherein the electromagnetic wave shielding filter comprises a mesh-patterned conductive material.

9.  A filter assembly as claimed in claim 8, wherein the conductive material includes at least one of Cu, Ag, Al, Pt, Au, Fe or an alloy thereof.

10. A filter assembly as claimed in one of Claims 1 to 7, wherein the electromagnetic wave shielding filter comprises a metal layer and a metal oxide layer stacked on one another.

11. A plasma display device, comprising:

    a panel assembly including first and second substrates;
    a chassis base assembly attached to the panel assembly and including driving circuit boards which transfer electrical signals to and from the panel assembly; and
    a filter, the said filter assembly being as set out in any preceding claim.

12. A plasma display device as claimed in claim 11, wherein the filter assembly directly contacts a front surface of the first substrate.

13. A plasma display device as claimed in claim 11 or 12, wherein the filter maintains a transmittance of about 40%.

14. A plasma display device as claimed in claim 11, 12 or 13, further comprising a case adapted to accommodate the panel assembly, the chassis base and the filter assembly.

# FIG. 1

EP 1 845 550 A1

# FIG. 2

## FIG. 3

258 257 256 255 254     211

253    251    252

250

## FIG. 4

258 257 255 254 252    211

FIG. 5

257 255 254 252   211

FIG. 6

258 255 254 252   211

# FIG. 7

252

252a

252b

A

# FIG. 8

252a

252b

# FIG. 9

# FIG. 10

**European Patent Office**

**EUROPEAN SEARCH REPORT**

Application Number

EP 07 25 1554

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | EP 0 910 107 A1 (FUJITSU GENERAL LTD [JP]) 21 April 1999 (1999-04-21) * figures 6,10 * * paragraphs [0007], [0017], [0019], [0031], [0032] * | 1-14 | INV. H01J17/49 |
| X | EP 1 316 983 A (ASAHI GLASS CO LTD [JP]) 4 June 2003 (2003-06-04) * figure 1 * * paragraphs [0007], [0013], [0021], [0022], [0034] * | 1,3-5 | |
| X | EP 1 196 018 A (NISSHIN SPINNING [JP]; HASEGAWA CHEM IND [JP]) 10 April 2002 (2002-04-10) * figure 1 * * paragraphs [0036], [0042], [0052], [0054] - [0056], [0087] * | 1,6,7,13 | |
| X | EP 1 107 025 A2 (NITTO DENKO CORP [JP]) 13 June 2001 (2001-06-13) * paragraphs [0068], [0069] * | 1 | |

| | | | TECHNICAL FIELDS SEARCHED (IPC) |
|---|---|---|---|
| | | | H01J |

The present search report has been drawn up for all claims

| Place of search | Date of completion of the search | Examiner |
|---|---|---|
| Munich | 19 July 2007 | Feeney, Orla |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

**EP 1 845 550 A1**

## ANNEX TO THE EUROPEAN SEARCH REPORT
## ON EUROPEAN PATENT APPLICATION NO.

EP 07 25 1554

This annex lists the patent family members relating to the patent documents cited in the above-mentioned European search report.
The members are as contained in the European Patent Office EDP file on
The European Patent Office is in no way liable for these particulars which are merely given for the purpose of information.

19-07-2007

| Patent document cited in search report | | Publication date | Patent family member(s) | | Publication date |
|---|---|---|---|---|---|
| EP 0910107 | A1 | 21-04-1999 | AU | 721435 B2 | 06-07-2000 |
| | | | AU | 7336796 A | 01-10-1997 |
| | | | CA | 2248768 A1 | 18-09-1997 |
| | | | WO | 9734313 A1 | 18-09-1997 |
| | | | US | 6229085 B1 | 08-05-2001 |
| EP 1316983 | A | 04-06-2003 | CN | 1422112 A | 04-06-2003 |
| | | | JP | 2003168887 A | 13-06-2003 |
| | | | KR | 20030044823 A | 09-06-2003 |
| | | | TW | 257841 B | 01-07-2006 |
| | | | US | 2003102790 A1 | 05-06-2003 |
| EP 1196018 | A | 10-04-2002 | JP | 2002116700 A | 19-04-2002 |
| | | | KR | 20020027219 A | 13-04-2002 |
| | | | TW | 521562 B | 21-02-2003 |
| | | | US | 2002042162 A1 | 11-04-2002 |
| EP 1107025 | A2 | 13-06-2001 | DE | 60033360 T2 | 31-05-2007 |
| | | | US | 6569516 B1 | 27-05-2003 |

EPO FORM P0459

For more details about this annex : see Official Journal of the European Patent Office, No. 12/82

19